# FASCICULE DE BREVET EUROPEEN

(11) **EP 0 603 673 B1**
(45) Date de publication et mention de la délivrance du brevet: **06.11.1996**
(21) Numéro de dépôt: 93119938.4
(22) Date de dépôt: 10.12.1993
(51) Int. Cl.: C23C 28/00, C22C 30/00, C22C 5/04

(54) **Objet présentant un revêtement de coloration rosée**
Gegenstand mit rosafarbiger Beschichtung
Object having a pink coating

(30) Priorité: 23.12.1992 FR 9215816
(43) Date de publication de la demande: 29.06.1994
(73) Titulaire: Eta SA Fabriques d'Ebauches, 2540 Grenchen (CH)
(72) Inventeur: Riedl, Robert, CH-5726 Unterkulm (CH); Randin, Jean-Paul, CH-2016 Cortaillod (CH)
(74) Mandataire: de Montmollin, Henri

(56) Documents cités:
- EP-A- 0 322 812
- DE-A- 3 304 598
- US-A- 4 804 517
- PATENT ABSTRACTS OF JAPAN vol. 14, no. 505 (C-775)5 Novembre 1990 & JP-A-02 209 464 (SUMITOMO METAL MINING CO LTD) 20 Aoüt 1990
- PATENT ABSTRACTS OF JAPAN vol. 13, no. 262 (C-608)(3610) 16 Juin 1989 & JP-A-10 065 274 (SEIKO EPSON CORP) 10 Mars 1989
- PATENT ABSTRACTS OF JAPAN vol. 10, no. 318 (C-381)(2374) 29 Octobre 1986 & JP-A-61 127 863 (SEIKO INSTR AND ELECTRONICS LTD) 16 Juin 1986

## Description

La présente invention est relative à un objet présentant un revêtement de coloration rosée reposant sur un substrat formant le corps de l'objet, ledit revêtement comprenant une première couche de nitrure d'un élément choisi dans le groupe comprenant Ti, Zr, Hf, ou d'un mélange de ces éléments ladite première couche incluant au moins un élément choisi parmi Al, C et des éléments des groupes Vb et VIb.

On a déjà proposé un revêtement de coloration rosée mettant en oeuvre une seule couche de nitrure comme défini ci-dessus. On se référera pour cela au document publié en février 1991 par la société Leybold AG (DE) et intitulé : "What you ever wanted to know about deco coatings", Part III. Un chapitre de cette publication est consacré à l'obtention de la coloration appelée "rosy pink" soit un rose qui tire sur le rouge et qui est actuellement à la mode pour recouvrir des montures de lunettes. Jusqu'ici un tel revêtement qui soit assez dur pour résister à l'usure et aux rayures n'a pas été proposé et on a dû se contenter d'alliages relativement tendres et ternes comprenant par exemple des composés intermétalliques comportant essentiellement du palladium et de l'indium, la couleur de ce composé variant du jaune pâle à la couleur or et orrose. Un tel composé dont la dureté ne dépasse guère les 350 HV₁ est décrit dans le brevet US-A-4 804 517.

La demande de brevet JP-A-61127863 décrit un revêtement de couleur rose comprenant une couche rose de carbonitrure de titane recouverte par une couche également rose d'alliage d'or et de palladium. Toutefois, la couleur de ce revêtement n'est pas la couleur "rosy pink" souhaitée.

La demande de brevet DE-A-3304598 décrit des alliages à base de palladium et d'indium dont la couleur va du jaune clair à la couleur lilas mais rien dans ce document n'indique ni ne suggère qu'un ou plusieurs de ces alliages peuvent être déposés sur une couche de nitrure de couleur rosy pink pour augmenter sa clarté, sans modifier nettement sa couleur.

Une couleur peut être caractérisée par sa teinte, sa clarté et sa saturation. Des appareils, par exemple le colorimètre Minolta CR200 et le spectrophotomètre Perkin-Elmer 555 équipé d'une sphère d'intégration, convertissent toutes les couleurs situées dans la plage de perception humaine dans un code numérique qui permet à plusieurs personnes d'exprimer très précisément la couleur dont elles parlent. Ce code est défini dans une recommandation du Comité International de l'Eclairage (CIE, 1976). Ce système exprime l'espace couleur L* a* b*. Lorsqu'une couleur est exprimée dans ce système, la clarté est indiquée par la valeur L* alors que la teinte et la saturation sont exprimée par a* et b* : a* et b* indiquent deux axes de couleur, a* l'axe rouge-vert et b* l'axe jaune-bleu. Les valeurs positives de a* correspondent au rouge, négatives au vert alors que les valeurs positives de b* correspondent au jaune et négatives au bleu. La valeur de la clarté L* peut varier de O (noir) à 100 (blanc).

La publication de la société Leybold dont il a été question ci-dessus tente de définir la coloration rosy pink par les valeurs suivantes : L* = 73, a* = 8 et b* = 5. Pour y parvenir plusieurs compositions ont été proposées qui sont toutes une couche dure (> 600 HV₁) de nitrure appliquée sur un substrat par déposition physique en phase vapeur (PVD), ces couches s'approchant toutes tant soit peu de la définition de couleur indiquée pour le rosy pink. Ces compositions sont données ci-après avec la coloration correspondante.

| | |
|---|---|
| Ti₉₀Al₁₀Nₓ | L* = 57, a* = 9, b* = 5 |
| Ti₉₅Al₅Nₓ | L* = 57, a* = 10, b* = 8 |
| Ti₈₀Al₁₀V₁₀Nₓ | L* = 60, a* = 7, b* = 7 |
| Zr₈₀Al₂₀Nₓ | L* = 53, a* = 6, b* = 6 |
| Ti₈₀Cr₂₀Nₓ | L* = 63, a* = 4, b* = 9 |
| TiCₓN_{y} | L* = 61, a* = 7, b* = 5 |

A ces compositions, le demandeur ajoutera la composition suivante qu'il a produite avec succès :

| | |
|---|---|
| Zr₈₀Ti₂₀CₓN₁₋ₓ | L* = 62, a* = 7, b* = 7 |

Si le nitrure de titane (TiN) est connu pour sa couleur jaune, proche de celle de l'or, l'adjonction d'aluminium, ou de chrome, ou de carbone à ce nitrure a pour conséquence l'apparition de la tendance au rouge et finalement une teinte qui peut s'apparenter au rosy pink recherché. Cependant on constate que dans tous les cas mentionnés ci-dessus, la clarté L* est beaucoup trop basse, ce qui conduit à une couleur terne non attractive. Or il a été constaté que pour rendre cette coloration attractive, une clarté L* ayant au moins une valeur de 70 est absolument nécessaire.

Pour y parvenir, la présente invention imagine d'appliquer sur la première couche de nitrure une seconde couche constituée d'un mélange de palladium (Pd) et d'indium (In).

L'invention va être maintenant expliquée en détail.

Sur le corps de l'objet qui peut être une monture de lunette ou une pièce constitutive d'une boîte de montre (carrure, lunette, fond, etc.) on dépose un revêtement de coloration rosée. Ce revêtement comporte une première couche de nitrure (N) d'un élément choisi dans le groupe comprenant du titane (Ti), du Zirconium (Zr) et du Hafnium (Hf), ou d'un mélange de ces éléments, cette première couche incluant au moins un élément choisi parmi l'aluminium (Al), le carbone (C) et des éléments des groupes Vb et VIb. Cette couche sera déposée préférablement par un procédé PVD dont l'épaisseur peut varier entre 0,1 et 2,5 µm. Le choix des éléments sera dicté par la couleur que l'on désire obtenir (voir tableau ci-dessus). On notera ici que pendant la déposition, on peut ajouter de l'oxygène, ce qui accentue encore la tendance au rouge. La couche obtenue est très dure, sa dureté dépassant les 600 HV₁, ce qui rend l'objet résistant à l'usure et surtout aux rayures.

Sur cette première couche, on dépose une seconde couche d'un mélange constitué de palladium (Pd) et d'indium (In). Ce second dépôt a pour but d'augmenter la clarté L* comme dit plus haut et constitue de surcroît une mise en couleur très précise de la teinte a* et b* que l'on désire obtenir.

Comme on l'a aussi dit plus haut, cette seconde couche, dont l'épaisseur peut être limitée entre 0,05 et 1 µm, n'est pas particulièrement résistante aux rayures. Si cette seconde couche n'était pas précédée de la première, il serait nécessaire d'augmenter son épaisseur, par exemple au-delà de 10 µm , pour lui assurer une durée de vie raisonnable. Cependant, on comprendra qu'une rayure dans une couche épaisse est bien plus visible que dans une couche mince où elle se trouve être moins profonde. En conséquence, les rayures appliquées sur la seconde couche mince de l'invention sont peu profondes donc moins visibles, car limitées par la première couche de nitrure, en principe inrayable. Quant à l'usure normale, par frottement par exemple, elle se trouve aussi être moins visible dans le revêtement de l'invention, puisqu'une fois la seconde couche disparue, subsiste la première, en principe inusable, mais de couleur apparentée à la seconde.

Pour revenir à la seconde couche de PdIn mentionnée plus haut, des mesures ont montré une coloration définie par L* = 70, a* = 14 et b* = 3 si le mélange présente une composition stoechiométrique, c'est-à-dire 48,3 % en poids de Pd et 51,7 % en poids d'In.

Pour obtenir une coloration se rapprochant du rosy pink souhaité, on propose un mélange constituée principalement de palladium et d'indium auquel on ajoute de surcroît un élément ternaire choisi parmi Mg, Al, Si, Sn, Sb, Zn, Cu, Ag, Au, Zn, Y, Ti, Zr, Hf et Ni.

En particulier, un mélange comportant 46 à 58 % en poids de palladium, 42 à 54 % en poids d'indium et 0,5 à 5 % en poids d'aluminium donne des résultats satisfaisants. Plus précisément, le mélange 47,49 % poids Pd, 51,25 % poids In et 1,26 % poids Al donne une dureté de 284 HV₁ et une coloration L* = 70, a* = 8 et b* = 5 ce qui approche de très près la coloration rosy pink définie plus haut (L* = 73, a* = 8, b* = 5).

De même, un mélange comportant 42 à 52 % en poids de palladium, 42 à 54 % en poids d'indium et 0,5 à 6 % en poids de cuivre donne également satisfaction. Plus précisément, le mélange 45,15 % poids Pd, 52,52 % poids In et 2,33 % poids Cu donne une dureté de 242 HV₁ et une coloration L* = 71, a* = 8 et b* = 4, ce qui est également proche de la coloration rosy pink dont les valeurs sont rappelées au paragraphe précédent.

Il faut noter également qu'en dehors de la coloration rosy pink recherchée, l'alliage PdIn, en particulier de la phase intermétallique β-PdIn, peut présenter une coloration s'apparentant à celle de l'or, d'où l'intérêt de son utilisation pour des raisons économiques, le palladium, bien que classé métal précieux, étant plusieurs fois moins cher que l'or.

La seconde couche considérée ici a été déposée par procédé PVD, comme la première couche. Le principe est de bombarder la surface d'une cible du matériau à déposer avec des ions, en général Ar⁺, qui ont une énergie suffisante pour éjecter un ou plusieurs atomes de la cible; ces atomes sont ainsi projetés vers le substrat où ils se déposent pour former un revêtement.

## Revendications

1. Objet présentant un revêtement de coloration rosée tirant sur le rouge ("rosy pink"), sur un substrat qui constitue le corps de l'objet, ledit revêtement comprenant une première couche de nitrure d'un élément choisi dans le groupe comprenant Ti, Zr, Hf, ou d'un mélange de ces éléments, ladite première couche incluant au moins un élément choisi parmi Al, C et des éléments des groupes Vb et VIb, pour avoir une coloration rosée tirant sur le rouge, et une seconde couche surmontant ladite première couche pour augmenter la clarté (L*) dudit revêtement, caractérisé par le fait que ladite seconde couche est faite d'un mélange constitué au moins de palladium et d'indium.

2. Objet selon la revendication 1, caractérisé par le fait que le mélange de la seconde couche est une composition stoechiométrique de palladium et d'indium.

3. Objet selon la revendication 1, caractérisé par le fait que le mélange de la seconde couche est constitué principalement de palladium et d'indium et que ce mélange contient en plus un élément ternaire choisi parmi Mg, Al, Si, Sn, Sb, Zn, Cu, Ag, Au, Y, Ti, Zr, Hf et Ni.

4. Objet selon la revendication 3, caractérisé par le fait que le mélange de la seconde couche comporte 46 à 58 % en poids de palladium, 42 à 54 % en poids d'indium et 0,5 à 5 % en poids d'aluminium.

5. Objet selon la revendication 3, caractérisé par le fait que le mélange de la seconde couche comporte 42 à 52 % en poids de palladium, 42 à 54 % en poids d'indium et 0,5 à 6 % en poids de cuivre.

6. Objet selon l'une quelconque des revendications 1 à 5, caractérisé par le fait qu'il est une boîte de montre ou au moins une partie constitutive de celle-ci.

## Patentansprüche

1. Gegenstand mit einer ins Rote spielenden rosa Beschichtung ("rosy pink") auf einem Substrat, das den Korpus des Gegenstandes bildet, welche Beschichtung eine erste Schicht aus dem Nitrid eines Elementes ist, gewählt aus der Gruppe umfassend Ti, Zr, Hf, oder einem Gemisch dieser Elemente, welche erste Schicht mindestens ein Element enthält, gewählt unter Al, C und den Elementen der Gruppen Vb und VIb zum Erzielen einer ins Rote gehenden rosa Färbung, und eine zweite Schicht umfaßt, die der ersten Schicht überlagert ist, um die Klarheit (L*) der Beschichtung zu verbessern, dadurch gekennzeichnet, daß die zweite Schicht aus einem Gemisch, gebildet aus mindestens Palladium und Indium, besteht.

2. Gegenstand nach Anspruch 1, dadurch gekennzeichnet, daß das Gemisch der zweiten Schicht eine stöchiometrische Zusammensetzung von Palladium und Indium ist.

3. Gegenstand nach Anspruch 1, dadurch gekennzeichnet, daß das Gemisch der zweiten Schicht hauptsächlich aus Palladium und Indium gebildet ist und daß dieses Gemisch zusätzlich ein ternäres Element enthält, gewählt unter Mg, Al, Si, Sn, Sb, Zn, Cu, Ag, Au, Y, Ti, Zr, Hf und Ni.

4. Gegenstand nach Anspruch 1, dadurch gekennzeichnet, daß das Gemisch der zweiten Schicht 46 bis 58 Gew.-% Palladium, 42 bis 54 Gew.-% Indium und 0,5 bis 5 Gew.-% Aluminium enthält.

5. Gegenstand nach Anspruch 3, dadurch gekennzeichnet, daß das Gemisch der zweiten Schicht 42 bis 52 Gew.-% Palladium, 42 bis 54 Gew.-% Indium und 0,5 bis 6 Gew.-% Kupfer enthält.

6. Gegenstand nach einem der Ansprüche 1 bis 5, dadurch gekennzeichnet, daß er ein Uhrgehäuse oder mindestens ein Bauteil desselben ist.

## Claims

1. Object having a rosy pink colored covering on a substrate forming the body of the object, said covering comprising a first layer of nitride of an element chosen from the group comprising Ti, Zr, Hf, or a mixture of these elements, said first layer including at least an element chosen amongst Al, C and elements of the groups Vb and VIb to have a rosy pink color, and a second layer covering said first layer in order to increase the clarity (L*) of said covering, characterized by the fact that said second layer is formed of a mixture constituted of at least palladium and indium.

2. Object according to claim 1, characterized by the fact that the mixture of the second layer is a palladium and indium stoechiometric composition.

3. Object according to claim 1, characterized by the fact that the mixture of the second layer is constituted principally of palladium and indium and that this mixture also comprises a tertiary element chosen amongst Mg, Al, Si, Sn, Sb, Zn, Cu, Ag, Au, Zn, Y, Ti, Zr, Hf and Ni.

4. Object according to claim 3, characterized by the fact that the mixture of the second layer comprises 46 to 58 % weight of palladium, 42 to 54 % weight indium and 0.5 to 5 % weight of aluminium.

5. Object according to claim 3, characterized by the fact that the mixture of the second layer comprises 42 to 52 % weight of palladium, 42 to 54 % weight of indium and 0.5 to 6 % weight of copper.

6. Object according to one of the claims 1 to 5, characterized by the fact that it is a watch-case or at least a part constituting a watch-case.
